## Europäisches Patentamt
## European Patent Office
## Office européen des brevets

(19)

(11) Numéro de publication : **0 013 718**
**B1**

(12)

# FASCICULE DE BREVET EUROPÉEN

(45) Date de publication du fascicule du brevet : **17.03.82**

(51) Int. Cl.³ : **H 05 K   7/16, H 05 K   7/18**

(21) Numéro de dépôt : **79104869.7**

(22) Date de dépôt : **04.12.79**

(54) Support pour panneaux à circuits imprimés monté sur pivot.

(30) Priorité : **05.01.79 US 1102**

(43) Date de publication de la demande : **06.08.80 (Bulletin 80/16)**

(45) Mention de la délivrance du brevet : **17.03.82 Bulletin 82/11**

(84) Etats contractants désignés : **DE FR GB**

(56) Documents cités :
**AU - B - 417 586**
**DE - A1 - 2 704 671**
**DE - B1 - 2 409 318**
**DE - B2 - 2 620 758**
**DE - U - 1 813 553**

(73) Titulaire : **International Business Machines Corporation**

**Armonk, N.Y. 10504 (US)**

(72) Inventeur : **Kekas, Dennis Harry**
**3425 Horton Street**
**Raleigh, NC 27607 (US)**
Inventeur : **Mac Adams, Ronald Prestly**
**5104 New Bern Avenue**
**Raleigh, NC 27610 (US)**
Inventeur : **Polischuk-Sawtschenko, Alexander**
**Rt. 6, Box 348-8**
**Raleigh, NC 27612 (US)**

(74) Mandataire : **Colas, Alain**
**COMPAGNIE IBM FRANCE Département de Propriété Industrielle**
**F-06610 - La Gaude (FR)**

Imprimerie Jouve, 18, rue St-Denis, 75001 Paris, France

## Support pour panneaux à circuits imprimés monté sur pivot

### Domaine technique

La présente invention concerne des panneaux à circuits imprimés utilisés dans des dispositifs de traitement de données, et, plus particulièrement, un support, pour de tels panneaux à circuits imprimés, monté sur pivot.

### Etat de la technique antérieure

Les dispositifs de traitement de données emploient normalement des panneaux à circuits imprimés pour supporter physiquement et connecter électriquement des composants discrets et des microplaquettes de circuits intégrés qui remplissent les fonctions électroniques nécessaires au fonctionnement de ces dispositifs. Suivant la complexité d'un dispositif particulier, on peut aller jusqu'à utiliser plusieurs douzaines de panneaux à circuits imprimés.

De nombreux types différents de supports pour panneaux à circuits imprimés sont connus, par exemple, de la demande de brevet DE 2 409 318. Bien que la conception des supports peut varier dans le détail, tous les supports connus possèdent certaines qualités communes. Les supports disponibles sont faits à partir d'un certain nombre de pièces discrètes qui sont assemblées et fixées par des adhésifs ou par des moyens de fixation classiques, du type à vis. Une fois les supports assemblés, ils sont habituellement fixés de façon permanente à un châssis ou à une paroi du dispositif de traitement de données dans lequel ils doivent être utilisés.

Les supports de panneau connus présentent un certain nombre de problèmes. Etant donné qu'ils sont faits à partir de pièces discrètes, la fabrication des supports est nécessairement précédée de la fabrication, de l'acheminement et de l'entrepôt propres aux différentes pièces. Toutes ces opérations séparées prennent du temps. Le temps passé sur les opérations séparées initiales représente une dépense qui se répercute dans le prix de revient du produit final.

L'assemblage d'un support à partir d'un certain nombre de pièces discrètes représente également une opération qui demande du temps et qui, souvent, exige des outils spéciaux. Le temps requis pour l'assemblage et le besoin d'avoir des outils pour procéder à cet assemblage, qu'ils soient spéciaux ou non, augmentent de façon importante le prix de revient du support fini.

Un autre inconvénient rencontré dans les supports de panneau à circuits imprimés connus est qu'il n'est pas facile d'entretenir des panneaux qui sont montés dans ce type de support. Il se peut qu'un inspecteur souhaite tester un panneau à circuits imprimés en appliquant, à partir des contacts de ce panneau, des signaux de test au panneau. A l'état actuel des choses, il faut enlever le panneau à circuits imprimés du support pour permettre ce type de diagnostic. Le fait d'avoir à enlever un panneau pour procéder à un test peut s'avérer peu pratique et long. En outre, les défauts de fonctionnement du dispositif sont quelquefois le résultat d'une dégradation des contacts au niveau des panneaux de connexion à broches multiples qui servent d'interface électrique entre les panneaux à circuits imprimés et les connecteurs de câbles qui alimentent divers éléments tels que des dispositifs d'affichage, et autres dispositifs semblables. Lorsqu'un panneau à circuits imprimés est enlevé du support pour être soumis à un test, les tests, bien sûr ne tiennent pas compte des problèmes qui peuvent se présenter à l'interface du panneau à circuits imprimés et des panneaux de connexion à broches multiples qui sont rattachés au support.

### Exposé de l'invention

Le but de l'invention est de pallier les inconvénients cités ci-dessus en fournissant un support de panneau à circuits imprimés tel que défini dans la revendication 1.

Les avantages de la présente invention ressortiront mieux de l'exposé qui suit, fait en référence aux dessins annexés à ce texte, qui représentent un mode de réalisation préféré de celle-ci.

### Brève description des figures

La Figure 1 représente une vue en perspective d'un support pour panneau à circuits imprimés construit, conformément au principe de la présente invention, sur la base d'un dispositif de traitement de données.

La Figure 2 représente une vue de côté du support de panneau à circuits imprimés, le réceptacle du support ayant pivoté dans une position de service.

La Figure 3 représente une vue en perspective montrant le réceptacle du panneau à circuits imprimés, un panneau de broches de connexion et une plaquette de renfort pour maintenir en place le panneau de broches.

La Figure 4 représente une vue en perspective d'un réceptacle inversé montrant certains détails des éléments de positionnement et de verrouillage du panneau de broches et de la plaquette de renfort.

La Figure 5 représente une vue en perspective de la base du dispositif de traitement de données alors que le réceptacle est enlevé, afin de montrer la structure des montants et des moyens de verrouillage du réceptacle, et

La Figure 6 représente une vue en perspective agrandie du moyen de verrouillage du réceptacle utilisé pour maintenir le réceptacle en position normale.

### Mode de réalisations préférées de l'invention

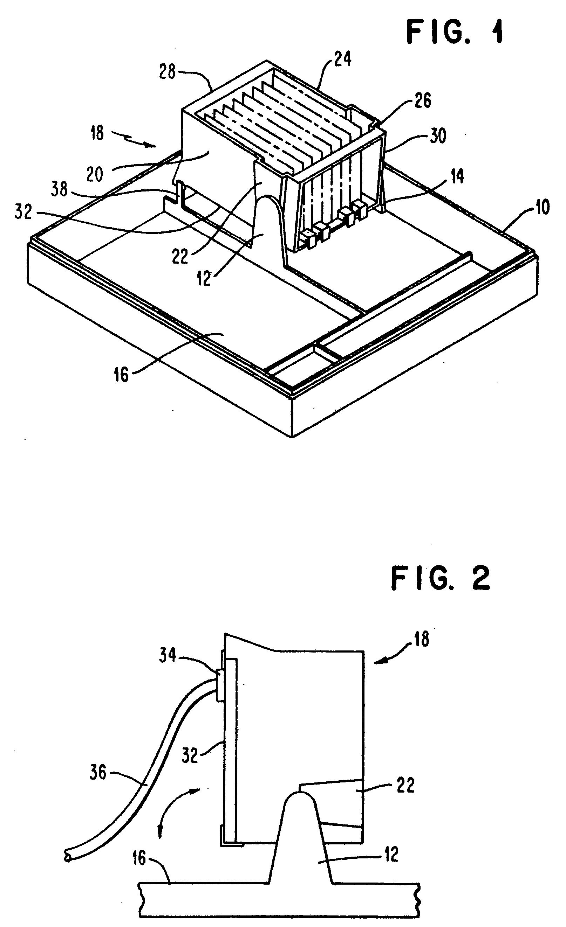

La Figure 1 représente un support pour panneau à circuits imprimés construit, conformément aux principes de la présente invention, comme faisant partie d'un dispositif de traitement de données ayant une section de base 10. Etant donné que la présente invention peut être utilisée dans de nombreux types différents de dispositifs de traitement de données, la section de base 10 n'est montrée qu'à titre d'exemple.

Le support comporte une paire de montants ou éléments-support espacés, 12 et 14, qui s'étendent vers le haut à partir de la surface 16 de la section de base 10. Les montants 12 et 14 supportent un réceptacle rectangulaire 18. Le réceptacle 18 comprend une première paroi latérale 20 pourvue d'une partie en saillie et une seconde paroi latérale 24 ayant une partie en saillie semblable 26. Comme cela sera expliqué de façon plus détaillée dans la suite, les parties en saillie 22 et 26 sont pourvues d'ouverture pour recevoir des ergots prévus sur la surface interne des montants 12 et 14. Les ergots et les ouvertures faites dans les parois latérales définissent un axe autour duquel peut pivoter le réceptacle 18. Les extrémités du réceptacle 18 sont formées par les parois 28 et 30.

Les panneaux à circuits imprimés sont chargés côte à côte dans le réceptacle 18 par la partie supérieure ouverte, les bords porteurs de contacts des panneaux à circuits imprimés étant adjacents à la paroi inférieure 32 du réceptacle 18. En référence à la Figure 2, chaque panneau à circuits imprimés est connecté par un connecteur à un câble extérieur à fils multiples ; sur la figure, seul un connecteur et un câble ont été représentés à des fins de simplicité mais il est bien entendu que le nombre de connecteurs et de câbles ne se limitent pas à un. Les câbles transmettent des signaux entre les panneaux à circuits imprimés et d'autres composants de terminal tels que claviers, dispositifs d'affichage, et autres.

En se reportant à nouveau à la Figure 1, le réceptacle 18 est représenté dans sa position de fonctionnement, ou position normale, la paroi inférieure 32 étant parallèle à la surface 16 de la section de base 10. Le réceptacle 18 est maintenu dans cette position par un verrou dont seul l'élément de guidage 38 est visible sur la Figure 1. Une description plus détaillée du reste des composants du verrou sera donnée dans la suite.

En se reportant à la Figure 2, il est possible de faire pivoter le réceptacle 18 d'un angle d'environ 90° pour l'amener dans une position de service où la paroi inférieure 32 est perpendiculaire à la surface 16. Lorsque le réceptacle 18 a pivoté dans cette position, tout câble peut être manuellement enlevé pour permettre à l'inspecteur d'appliquer des signaux de test à un panneau à circuits imprimés se trouvant à l'intérieur du support, par l'intermédiaire des contacts de ce support. Les parties en saillie 22 et 26 viennent en contact avec des rails de maintien (non représentés), réalisées sur les surfaces internes des montants 12 et 14 afin d'empêcher tout déplacement du réceptacle au-delà de la position de service.

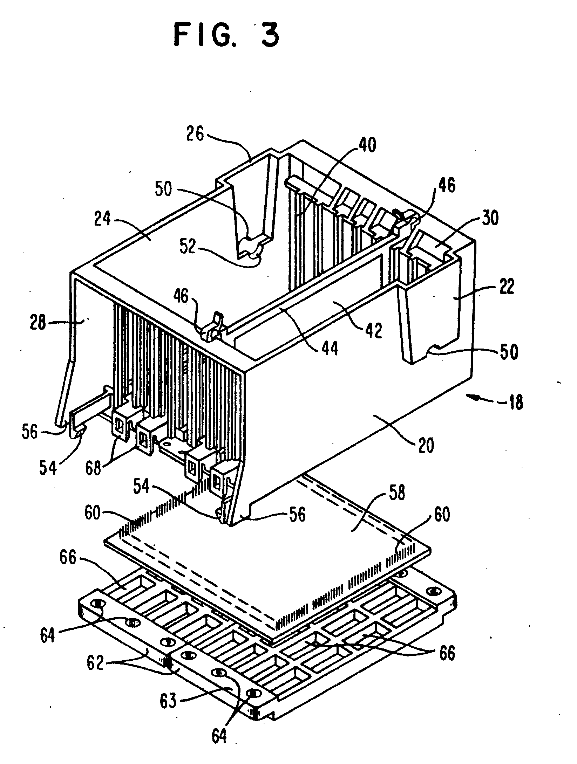

Le réceptacle 18 est représentée plus en détail sur la Figure 3. Le réceptacle est, de préférence, moulé dans un seul bloc dont les parois d'extrémités 28 et 30 sont pourvues d'éléments de guidage verticaux 40 pour recevoir les panneaux à circuits imprimés, tels que le panneau 42. Les panneaux sont de préférence montés dans des châssis tels que le châssis 44. Un type de châssis 44 particulièrement utile comporte des butées semi-escamotables 46 qui peuvent pivoter à chaque extrémité du châssis. Lorsque le panneau 42 est inséré dans le réceptacle en l'alignant dans un des éléments de guidage verticaux 40 et en appuyant sur le milieu du châssis 44, les butées 46 subissent une poussée vers le haut et sont forcées vers l'extérieur du réceptacle dès qu'elles viennent en contact avec le bord supérieur des parois d'extrémité 28 et 30, ce qui permet de maintenir le châssis dans le réceptacle. En revanche, pour enlever le panneau du réceptacle, les butées 46 subissent manuellement, une poussée vers le bas ce qui permet d'amener vers l'extérieur du réceptacle le panneau au-dessus du niveau des autres panneaux du réceptacle. Le châssis 44 peut alors être saisi plus facilement pour dégager le panneau du réceptacle.

Dans la description précédente, il a été indiqué que les parois latérales 20 et 24 étaient pourvues chacune d'une ouverture réalisée dans les parties en saillie 22 et 26. Chaque ouverture est formée, en fait, par une première échancrure semi-circulaire 50 faite au bas de la partie en saillie 22 ou 26 et par une seconde échancrure semi-circulaire 52, opposée à la première échancrure et réalisée dans les parois 20 ou 24, à hauteur des bords inférieurs des parties 22 ou 26. Les deux échancrures 50 et 52, prises ensemble, servant d'axe et forment une ouverture circulaire qui peut recevoir un petit ergot semi-circulaire situé vers le montant 12 ou 14 qui leur est associé. Les parties 22 et 26 permettent de recevoir les ergots semi-circulaires sans que ces derniers ne dépassent de la surface interne des parois latérales, de fournir un espacement entre les montants et la surface externe des parois latérales, et de définir un épaulement pour empêcher le réceptacle de se déplacer au-delà de la position de service.

Le réceptacle 18 comprend également deux bras de verrouillage 54 qui font partie du verrou utilisé pour maintenir le réceptacle 18 à sa position normale. D'autres détails du verrou du réceptacle seront donnés dans la suite. Chacun des bras de verrouillage 54 est adjacent à une petite projection ou oreille 56 réalisées au coin des parois latérales 20 et 24. Comme cela sera également expliqué de façon plus détaillée dans la suite, les oreilles 56 sont utilisées pour maintenir le réceptacle 18 à sa position normale.

Des panneaux de connexion 58 comportant des broches qui traversent ces panneaux isolants permettent de connecter électriquement les panneaux à circuits imprimés du réceptacle 18. La Figure 3 ne représente qu'un seul panneau de connexion comportant quelques broches conductrices 60. Dans la pratique, on pourrait n'utiliser que la moitié du panneau dans le cas où le réceptacle 18 verrait sa capacité de panneaux réduite de moitié, voire moins. Tout panneau de broches conductrices doit comporter des réseaux de broches sur toute sa surface, l'espacement entre les broches étant égal à l'espacement entre les contacts bordant les panneaux à circuits imprimés contenus dans le réceptacle 18. Le panneau de broches 58 est maintenu rigide par une ou plusieurs plaques de renfort moulées 62 dont chacune comprend des ouvertures de positionnement de plaque 64 faite dans les rebords 63, et un quadrillage de pièces solidaires formant des ouvertures 66 dans lesquelles peuvent venir se loger les connecteurs. Les plaques de renfort 62 sont maintenues par un jeu de bras de verrouillage à ressort 68 placé dans la partie inférieure des parois d'extrémité 28 et 30.

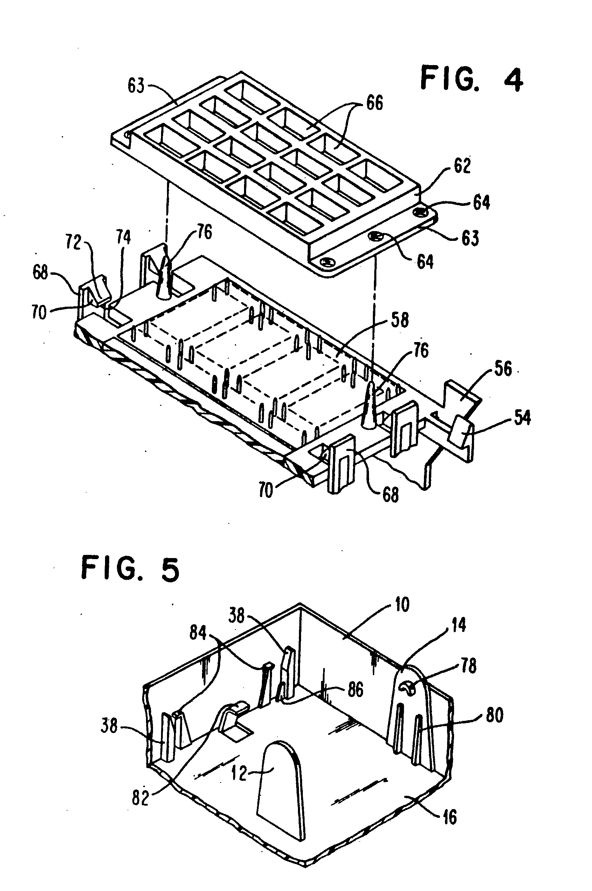

Comme le montre plus clairement la Figure 4, chaque bras de verrouillage 68 comprend, sur une partie interne, un ergot biseauté 70 dont la surface externe 72 est inclinée vers le centre du réceptacle 18 et dont la surface interne 74 est parallèle à la paroi inférieure du réceptacle.

Des broches de positionnement (non représentées), et situées sur le panneau de broches 58, viennent se loger dans des ouvertures faites dans la paroi inférieure du réceptacle 18 afin de mettre en position le panneau 58 lors de l'assemblage du support. Lorsque le panneau de broches 58 est en place, la plaque de renfort 62 est alignée au moyen de goupilles coniques 76 dépassant de la paroi inférieure du réceptacle 18. Alors que chaque extrémité du réceptacle 18 n'est pourvue que d'une seule goupille conique 76, chaque plaque de renfort 62 est pourvue de plusieurs ouvertures 64 faites dans les rebords 63, ce qui permet à la plaque de renfort d'être montée selon plusieurs positions différentes par rapport à la paroi inférieure du réceptacle. La surface externe inclinée 72 des bras de verrouillage 68 agit comme une surface à came qui force vers l'extérieur le bras de verrouillage 68 pour le dégager lorsque la plaque de renfort 62 est appuyée contre le réceptacle. Lorsque les rebords 63 des plaques de renfort libèrent les ergots 70, la flexibilité du matériau, dans lequel sont faits les bras de verrouillage, permet à chaque bras de revenir à sa position normale, position dans laquelle la surface interne 74 des bras 68 recouvre le rebord 63. Si besoin est, la plaque de renfort 62 peut être enlevée en séparant manuellement les uns des autres les bras de verrouillage 68 avant de dégager la plaque 62 des goupilles 76.

La Figure 5 représente les parties du support qui font, de préférence, partie intégrante de la base 16 du dispositif de traitement de données dans lequel est incorporé le support. L'ergot semi-circulaire 78 placé sur le montant 14 peut être un élément en forme de C solidaire au montant. Un ergot semblable (non représenté) se prolonge vers l'intérieur à partir du montant 12. La structure en forme de C de l'ergot facilite l'assemblage du réceptacle 18 au montant tout en permettant à ce réceptacle de pivoter doucement autour de l'axe défini par les ergots 78. Chacun des montants 12 et 14 comprend un rail de maintien 80 qui va contacter le bord d'une des parties en saillie 22 et 26 afin de limiter le parcours du réceptacle lorsqu'il pivote sur sa position de service. Dans cette position, le poids du réceptacle est supporté par les rails de maintien et les ergots des montants 12 et 14.

Le verrou du réceptacle comprend un ressort à lame 82 qui s'étend vers le haut à partir de la surface 16 de la section de base 10. Le ressort à lame 82, qui, de préférence, fait partie intégrante de la section 10, applique une force de rappel vers le haut sur la paroi inférieure du réceptacle 18 lorsque ce dernier se trouve en position normale. Le ressort à lame 82 force les bras de verrouillage 54 du réceptacle 18 à venir s'engager avec les piliers de verrouillage 84 qui s'étendent vers le haut à partir de la surface 16 de la section de base 10. Le pilier de verrouillage 84 a, de chaque côté, des éléments de guidage 38 qui sont pourvus à la base d'une butée d'arrêt 86.

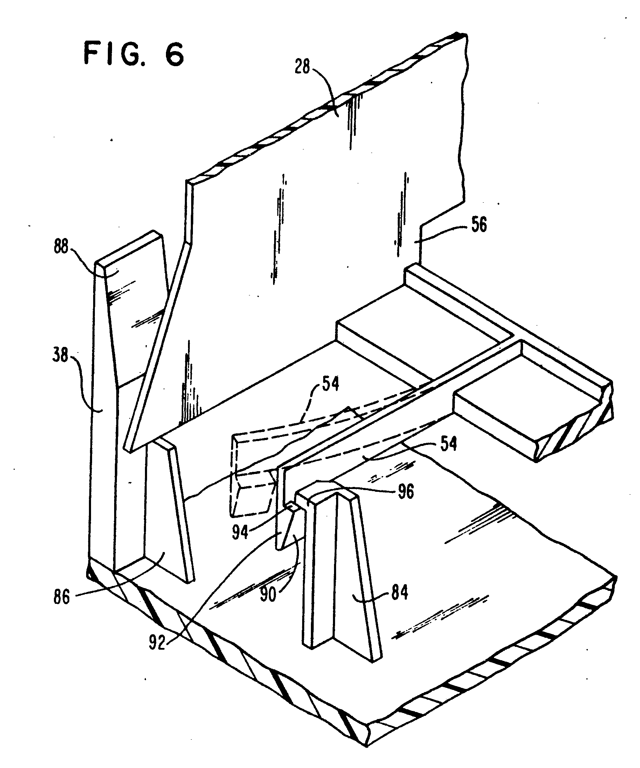

Les détails du verrou du réceptacle sont illustrés plus clairement sur la Figure 6 qui est une vue agrandie d'un coin du réceptacle 18 alors qu'il se trouve en position normale ou verrouillée.

Lorsque le réceptacle 18 se trouve tout d'abord fixé au montant 12 et 14 ou lorsqu'il revient de sa position de service, ce réceptacle est guidé vers sa position normale par les éléments de guidage 38 qui se terminent chacun par une partie bisautée 88. En se reportant plus particulièrement à la Figure 6, l'oreille 56, ou projection située sur la paroi latérale 28, descend, tout en étant en contact avec la partie bisautée 88, vers la butée d'arrêt 86. Durant ce mouvement descendant, une surface bisautée 90 de l'épaulement 92 du bras de verrouillage 54 force le bras de verrouillage 54 à se rétracter et à s'effacer lorsqu'il passe devant l'extrémité supérieure du pilier de verrouillage 84. A un certain point du mouvement descendant du réceptacle, la surface supérieure plane 94 de l'épaulement 92 va se trouver audessous de la saillie 96 du pilier 84. La flexibilité naturelle du bras de verrouillage 54 va faire revenir le bras 54 contre le pilier 84, l'épaulement 92 et la saillie 96 étant en position de verrouillage comme représentée en traits pleins sur la Figure 6. Le réceptacle 18 est rappelé vers le haut par le ressort à lame 82 afin d'assurer un bon verrouillage entre le bras 54 et le pilier 84. Le réceptacle peut quitter cette position normale ou verrouillée en écartant les bras de verrouillage 54 de leur pilier de verrouillage correspondant. La position écartée du bras de verrouillage 54 est représentée en pointillés sur la Figure 6.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Support pour panneaux à circuits imprimés, situé dans un dispositif de traitement de données électronique et comprenant un réceptacle, pour recevoir les panneaux à circuits imprimés, de forme parallélépipédique, comportant des parois d'extrémité opposées, des parois latérales opposées ainsi qu'une paroi inférieure, et étant monté de manière à pouvoir pivoter autour d'un axe entre une première position dans laquelle la paroi inférieure du réceptacle est sensiblement parallèle à une base du dispositif de traitement de données, à une seconde position de service, ledit support étant caractérisé en ce qu'il comprend :

des premier et second montants (12, 14) montés sur la base (10) du dispositif de traitement de données, ces montants étant respectivement pourvus d'ergots (78) montés sur leur face intérieure,

des ouvertures (50, 52) ménagées dans les parois latérales opposées (20, 24) du réceptacle et dans lesquelles viennent se placer les ergots (78), de telle sorte que le réceptacle est supporté par lesdits montants (12, 14) et peut pivoter autour de l'axe défini par les ergots, la seconde position limitant son débattement étant telle que la paroi inférieure (32) du réceptacle est sensiblement perpendiculaire à la base (10).

et en ce que chacune des parois latérales du réceptacle comprend une partie en saillie (22, 26) qui est parallèle et extérieure au reste de la paroi latérale, l'ouverture faite dans chacune des parois latérales étant définie par une première échancrure semi-circulaire (50) réalisée dans le bord inférieur de la partie en saillie et par une seconde échancrure semi-circulaire (52), de sens opposé, réalisée dans la paroi latérale et en dessous dudit bord inférieur et les deux échancrures (50, 52) définissant une ouverture circulaire destinée à recevoir ledit ergot, la longueur de cet ergot étant définie pour qu'il ne se prolonge pas au-delà de la surface interne de la paroi latérale du réceptacle.

2. Support selon la revendication 1, caractérisé en ce qu'il comporte en outre des moyens d'arrêt pour limiter le pivotement du réceptacle au-delà de la position de service, ces moyens d'arrêt comportant des rails de maintien (80) qui entrent en contact avec le bord des parties en saillie (22, 26) pour la limitation du pivotement, ces rails coopérant avec les ergots pour supporter et maintenir le réceptacle dans la position de service.

3. Support selon l'une quelconque des revendications 1 à 2, caractérisé en ce qu'il comprend en outre :

des panneaux de connexion (58) à broches multiples pour assurer un interface électrique entre les panneaux à circuits imprimés (42) portés par le réceptacle et des connecteurs de câbles externes associés au dispositif de traitement de données, et

des moyens de maintien pour retenir lesdits panneaux de connexion sur la paroi inférieure du réceptacle, ces moyens de maintien comportant :

au moins une plaque de renfort (62) pourvue d'ouvertures (66) destinées à recevoir les broches des panneaux de connexion et pourvue de trous de positionnement (64) destinés à recevoir des goupilles de positionnement (76) situées sur la paroi inférieure du réceptacle, à chaque goupille correspondant plusieurs trous afin de définir plusieurs positions possibles pour la plaque de renfort, et,

des moyens de verrouillage pour fixer chaque plaque de renfort audit réceptacle, les panneaux de connexion étant situés entre les plaques de renfort et la paroi inférieure du réceptacle, lesdits moyens de verrouillage comprenant plusieurs bras de verrouillage flexibles (68) situés sur la périphérie de la paroi inférieure dudit réceptacle, et, chaque bras de verrouillage bloquant l'ensemble panneaux de connexion-plaque de renfort sur ladite paroi inférieure.

4. Support selon l'une quelconque des revendications 1 à 3, caractérisé en ce qu'il comporte des moyens de verrouillage du réceptacle pour maintenir ce dernier dans sa première position, ces moyens de verrouillage comportant :

au moins un pilier de verrouillage (84) monté sur la base du dispositif, chacun des piliers de verrouillage comportant une saillie de verrouillage (96) qui s'étend parallèlement à la base et qui est située sur l'extrémité du pilier opposée à la base,

des éléments de guidage (38) terminés par une partie bisautée (88) pour guider le réceptacle vers sa position de verrouillage, et

au moins un bras de verrouillage (54) flexible monté sur le réceptacle, chacun desdits bras de verrouillage (54) comportant un épaulement (94) qui vient se verrouiller automatiquement sur la saillie de verrouillage (96) pour bloquer le réceptacle dans ladite première position, chacun desdits bras, et les deux éléments (94, 96) pouvant être déverrouillés pour libérer le réceptacle de sa condition bloquée.

**Claims**

1. A holder for printed circuit boards located in an electronic data processing device and including a parallelepipedal receptacle to receive the printed circuit boards said receptacle having opposed end walls, opposed side walls and a lower wall, and being mounted so as to pivot around an axis between a first position, in which the lower wall of the receptacle is substantially parallel with a base of the data processing device, and a second operating position, said holder being characterized in that it includes :

first and second support elements (12, 14) mounted on the base (10) of the data processing device, said elements being respectively provided with pins (78) mounted on their inner face,

openings (50, 52) in the opposed side walls (20, 24) of the receptacle into which said pins (78) are introduced so that the receptacle is supported by said support elements (12, 14) to pivot around the pin-defined axis, the second position limiting its movement being such that the lower wall (32) of the receptacle is substantially perpendicular to said base (10),

and that each of the side walls of the receptacle includes a protruding portion (22, 26) which is in parallel with, and external to the remaining side wall, the opening in each of the side walls being defined by a first semicircular indentation (50) in the lower edge of the protruding portion and by a second semicircular indentation (52), in the opposite direction, in the side wall and under said lower edge, both indentations (50, 52) defining a circular opening for receiving said pin, the length of said pin being defined so that it does not extend beyond the inner surface of the receptacle side wall.

2. A holder according to claim 1, characterized in that it furthermore includes stop means for preventing the receptacle from pivoting beyond the operating position, said stop means including support ribs (80) which contact the edge of the protruding portions (22, 26) to limit receptacle pivoting, said ribs engaging the pins to hold and support the receptacle in the operating position.

3. A holder according to any one of claims 1 to 2, characterized in that it furthermore includes :

multiple terminal connection boards (58) to provide an electrical interface between the printed circuit boards (42) in the receptacle and the external cable connectors associated with the data processing device, and

holding means for retaining said connection boards on the lower wall of the receptacle, said holding means including :

at least one reinforced plate (62) provided with openings (66) for receiving the terminals of the connection boards, and with positioning holes (64) for receiving the positioning pins (76) on the lower wall of the receptacle, several holes corresponding to each pin so as to define a plurality of possible positions for the reinforced plate, and

latching means for securing each reinforced plate to said receptacle, the connection boards being located between the reinforced plates and the lower receptacle wall, said latching means including several flexible latching arms (68) on the periphery of the lower wall of said receptacle and each latching arm securing the terminal board-reinforced plate assembly to said lower wall.

4. A holder according to any one of claims 1 to 3, characterized in that it comprises latching means for the receptacle for holding the latter in its first position, these latching means including :

at least one latching post (84) mounted on the device base, each latching post including a latching projection (96) in parallel with the base, which is located at the end of the post opposite the base,

guiding elements (38) terminated by a tapered portion (88) to guide the receptacle to its latching position, and

at least one flexible latching arm (54) mounted on the receptacle, each of said latching arms (54) comprising a shoulder (94) which automatically engages the latching projection (96) to latch the receptacle in said first position, each of said arms and the two elements (94, 96) being unlatchable to remove the receptacle from its latched condition.

## Ansprüche

1. Halterung für gedruckte Schaltungs-Tafeln in einer elektronischen Datenverarbeitungseinrichtung mit einem rechteckförmigen Behälter zur Aufnahme der gedruckten Schaltungs-Tafeln, die gegenüberliegende Längs- und Stirnwände und eine Bodenwand aufweist und so montiert ist, daß sie zwischen einer ersten Position, in der die Bodenwand des Behälters im wesentlichen parallel zu einer Basis der Datenverarbeitungseinrichtung steht, und einer zweiten Arbeitsposition um eine Achse geschwenkt werden kann, dadurch gekennzeichnet, daß die Halterung einschließt :

erste und zweite, auf die Basis (10) der Datenverarbeitungseinrichtung montierte Träger (12, 14), wobei diese Träger mit auf ihrer Innenseite angebrachten Zapfen (78) versehen sind,

Öffnungen (50, 52) in den gegenüberliegenden Seitenwänden (20, 24) des Behälters, zur Aufnahme der Zapfen (78), so daß der Behälter durch diese Träger (12, 14) getragen wird und sich um eine durch die Zapfen definierte Achse drehen kann, wobei die zweite Position seine Bewegung so begrenzt, daß die Bodenwand (32) des Behälters im wesentlichen senkrecht zur Basis (10) steht,

und daß jede der Seitenwände des Behälters einen vorspringenden Teil (22, 26) einschließt, der parallel zur und außerhalb der restlichen Seitenwand liegt, wobei die Öffnungen in jeder der Seitenwände definiert sind durch einen halbkreisförmigen, in dem unteren Rand des vorspringenden Teiles befindlichen Ausschnitt (50) und durch einen zweiten halbkreisförmigen Ausschnitt (52) entgegengesetzter Richtung, der sich in der Seitenwand und unterhalb dieses unteren Randes befindet, wobei die beiden Ausschnitte (50, 52) eine kreisförmige Öffnung zur Aufnahme des Zapfens definieren und die Länge dieses Zapfens so bestimmt ist, daß er nicht über die Innenseite der Seitenwand des Behälters hinausragt.

2. Halterung nach Anspruch 1, dadurch gekennzeichnet, daß sie außerdem Haltemittel einschließt, um die Behälterschwenkung über die Arbeitsposition hinaus zu beschränken, wobei diese Haltemittel Halteschienen (80) aufweisen, die den Rand der vorspringenden Teile (22, 26) zum Beschränken der Schwenkung berühren und diese Schienen zum Tragen und Festhalten des Behälters in der Arbeitsposition mit den Zapfen in Eingriff kommen.

3. Halterung nach einem der Ansprüche 1 bis 2, dadurch gekennzeichnet, daß sie weiterhin einschließt :

Verbindungsplatten (58) mit einer Vielzahl von Klemmen zum Herstellen einer elektrischen Kontaktfläche zwischen den von dem Behälter getragenen, gedruckten Schaltungs-Tafeln (42) und externen Kabelverbindungen, die der Datenverarbeitungseinrichtung zugeordnet sind, und

Haltemittel zum Festhalten der Verbindungsplatten auf der Bodenwand des Behälters, wobei diese Haltemittel einschließen :

wenigstens eine Verstärkungsplatte (62) mit zur Aufnahme der Klemmen der Verbindungsplatten bestimmten Öffnungen, die mit Einstellöchern (64) zur Aufnahme der auf der Bodenwand des Behälters befindlichen Einstellstifte (76) versehen sind, wobei ein Stift mehreren Löchern zugeordnet ist, um mehrere Positionen der Verstärkungsplatte zu ermöglichen, und

Verriegelungsmittel zum Befestigen jeder Verstärkungsplatte auf dem Behälter, wobei die Verbindungsplatten zwischen den Verstärkungsplatten und der Bodenwand des Behälters angebracht sind, und wobei die Verriegelungsmittel mehrere, auf der Peripherie der Bodenwand des Behälters angeordnete Verriegelungsarme einschließen und jeder Verriegelungsarm die Anordnung aus Verbindungstafeln und Verstärkungsplatte auf dieser Bodenwand blockiert.

4. Halterung nach einem der Ansprüche 1 bis 3, dadurch gekennzeichnet, daß sie Verriegelungsmittel des Behälters einschließt, um letzteren in seiner ersten Position zu halten, wobei diese Verriegelungsmittel aufweisen :

wenigstens eine auf der Basis der Vorrichtung angebrachte Verriegelungsstütze (84), wobei jede Verriegelungsstütze einen hervorspringenden Verriegelungsteil (96) aufweist, der sich parallel zur Basis erstreckt und sich am entgegengesetzten Ende der Basis befindet,

Führungselemente (38), die in einem abgeschrägten Teil (88) enden, um den Behälter in seine Verriegelungsposition zu führen, und

wenigstens einen flexiblen, auf dem Behälter angebrachten Verriegelungsarm (54), wobei jeder dieser Verriegelungsarme (54) einen schulterartigen Vorsprung (94) aufweist, der sich automatisch auf dem Verriegelungsteil (96) verriegelt, um den Behälter in dieser ersten Position zu blockieren, wobei jeder dieser Arme und die beiden Elemente (94, 96) entriegelt werden können, um den Behälter aus seiner blockierten Position freizugeben.

**FIG. 1**

**FIG. 2**

1

# FIG. 3

**FIG. 4**

**FIG. 5**

FIG. 6